(19) Europäisches Patentamt
European Patent Office
Office européen des brevets

(11) **EP 2 318 853 B1**

(12) **EUROPÄISCHE PATENTSCHRIFT**

(45) Veröffentlichungstag und Bekanntmachung des Hinweises auf die Patenterteilung:
**27.11.2013 Patentblatt 2013/48**

(21) Anmeldenummer: **09780187.2**

(22) Anmeldetag: **06.07.2009**

(51) Int Cl.:
**G01R 31/36** (2006.01)

(86) Internationale Anmeldenummer:
**PCT/EP2009/058508**

(87) Internationale Veröffentlichungsnummer:
**WO 2010/025974 (11.03.2010 Gazette 2010/10)**

(54) **VERFAHREN ZUR BERECHNUNG DES LADEZUSTANDES EINER BATTERIE**

METHOD FOR CALCULATING THE CHARGE STATE OF A BATTERY

PROCÉDÉ DE CALCUL DE L'ÉTAT DE CHARGE D'UNE BATTERIE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **26.08.2008 DE 102008041546**

(43) Veröffentlichungstag der Anmeldung:
**11.05.2011 Patentblatt 2011/19**

(73) Patentinhaber: **Robert Bosch GmbH
70442 Stuttgart (DE)**

(72) Erfinder:
• **MOTZ, Juergen
71711 Steinheim An Der Murr (DE)**
• **SCHOCH, Eberhard
70469 Stuttgart-Feuerbach (DE)**
• **ISKE, Burkhard
71272 Renningen-Malmsheim (DE)**
• **SCHMITZ, Christian
70439 Stuttgart (DE)**

(56) Entgegenhaltungen:
EP-A2- 1 308 738      WO-A1-2004/068157
US-A- 5 936 383        US-A- 6 137 292

**Beschreibung**

Stand der Technik

Die Erfindung betrifft ein Verfahren zur Ermittlung des Ladezustandes einer Batterie gemäß dem Oberbegriff des Patentanspruchs 1, sowie ein Steuergerät gemäß dem Oberbegriff des Patentanspruchs 9.

Der Ladezustand der Batterie SOC (State of Charge) ist eine wichtige Größe für das Bordnetzmanagement von Fahrzeugen. Zur Bestimmung des Ladezustands umfassen viele Fahrzeuge eine so genannte Batterie-Zustandserkennung. Diese Batterie-Zustandserkennung umfasst üblicherweise einen Algorithmus, der den Ladezustand SOC z. B. aus einer theoretischen Ruhespannung U0 berechnet. Die theoretische Ruhespannung U0 wird wiederum aus einem Anfangswert U00 und dem Integral des Batteriestroms IBatt, gegebenenfalls unter Berücksichtigung verschiedener Verlustfaktoren, berechnet. Für die theoretische Ruhespannung $U_0$ gilt z. B.:

$$U_0 = U00 + 1/C_0 \cdot \int I_{Batt}\, dt \qquad\qquad (1)$$

Dabei ist $C_0$ die Ersatzkapazität der Batterie und $U_{00}$ der Initial- oder Anfangswert der Ruhespannung. Der Anfangswert $U_{00}$ wird üblicherweise aus den Messwerten der Batteriespannung $U_{Batt}$, des Batteriestroms $I_{Batt}$ und der Batterietemperatur $T_{Batt}$ geschätzt.

Diese Berechnung der Ruhespannung $U_0$ liefert zu Beginn der Integration noch relativ genaue Ergebnisse. Ein Nachteil dieser Berechnung ist jedoch die mit der Zeit stetig zunehmende Abweichung des berechneten vom tatsächlichen Ladezustand SOC aufgrund des integralen Anteils von Gleichung (1). Dieser Fehler setzt sich in der Berechnung des Ladezustands SOC der Batterie fort, da gilt: SOC = f($U_0$).

Aus der Druckschrift EP 1 308 738 A2 ist ein Verfahren zum Ermitteln eines Ladezustands SOC eines Akkumulators bekannt geworden, bei dem ein erster Ladezustandswert durch Integration eines Akkumulatorstroms und ein zweiter Ladezustandswert durch Messung einer Ruhespannung $U_0$ ermittelt werden, die Ladezustände bewertet werden, und der Ladezustand ausgewählt wird, der als zuverlässiger bewertet wurde. Dadurch, dass der Ladezustand des Akkumulators nach mehr als einer Berechnungsmethode ermittelt wird, und die zuverlässigere Berechnung weiterverwendet wird, ist die Genauigkeit verbessert. Allerdings ist die Bewertung der Zuverlässigkeit der Berechnungsmethoden nicht sehr genau und lässt sich verbessern. Zudem lässt sich das Verfahren nicht auf die Ermittlung eines Ladezustands einer Batterie übertragen.

Offenbarung der Erfindung

Es ist daher die Aufgabe der vorliegenden Erfindung, ein Verfahren sowie eine Vorrichtung zu schaffen, mit dem bzw. der der Ladezustand SOC einer Batterie genauer bestimmt werden kann.

Gelöst wird diese Aufgabe gemäß der Erfindung durch die im Patenanspruch 1 angegebenen Merkmale. Weitere Ausgestaltungen der Erfindung ergeben sich aus den Unteransprüchen.

Ein wesentlicher Aspekt der Erfindung besteht darin, verschiedene Methoden zur Berechnung des Ladezustands einer Batterie zu analysieren und jeweils einen Fehler zu berechnen, der sich bei Anwendung der einzelnen Berechnungsmethoden ergeben würde. Gemäß der Erfindung wird der Ladezustand SOC der Batterie schließlich auf Basis derjenigen Berechnungs- oder Schätzmethode ermittelt, deren Fehler kleiner ist als der Fehler, der sich bei Anwendung einer anderen Methode ergeben würde. Dies hat den wesentlichen Vorteil, dass der Ladezustand relativ genau bestimmt werden kann.

Gemäß einer bevorzugten Ausführungsform der Erfindung wird zumindest eine Methode angewendet, die den Ladezustand SOC basierend auf der Ruhespannung der Batterie berechnet. Sollte sich in diesem Fall herausstellen, dass der Fehler der Ruhespannung gemäß einer ersten Berechnungsmethode größer ist als der Fehler der Ruhespannung, wenn diese gemäß einer anderen Methode berechnet werden würde, so wird der Ladezustand SOC der Batterie auf Basis der anderen Ruhespannung ermittelt. Wenn dagegen der Fehler der ersten Methode (z. B. entsprechend Gleichung 1) kleiner ist als der bei Anwendung einer anderen Methode zu erwartende Fehler, wird die Ruhespannung auf Basis der ersten Methode berechnet. Der ermittelte Wert der Ruhespannung kann z. B. als Initialwert in Gleichung (1) eingesetzt.

Der Ladezustand SOC der Batterie wird vorzugsweise mit derjenigen Methode bestimmt, die den kleinsten Fehler aufweist. Bei der Berechnung der Ruhespannung nach Gleichung (1) können verschiedene Verlustfaktoren berücksichtigt werden.

Eine zweite, aus dem Stand der Technik bekannte Methode zur Bestimmung der Ruhespannung besteht darin, die Ruhespannung aus den Batterie-Klemmengrößen, nämlich der Batteriespannung $U_{Batt}$, dem Batteriestrom $I_{Batt}$ und der Batterietemperatur $T_{Batt}$ zu schätzen. Dies geschieht vorzugsweise in Ruhephasen der Batterie, in denen die Batterie nicht oder nur geringfügig belastet wird und somit nur ein minimaler Batteriestrom fließt. Gemäß der Erfindung wird vorzugsweise auch der Fehler berechnet, der sich bei Anwendung dieser Methode ergeben würde. Dieser Fehler wird dann mit dem Fehler verglichen, der sich bei der Berechnung der Ruhespannung gemäß der Integrationsmethode (entsprechend Gleichung (1)) oder einer anderen Methode ergeben würde.

Eine dritte, aus dem Stand der Technik bekannte Methode zur Bestimmung der Ruhespannung besteht darin, die Ruhespannung bei Vollladung der Batterie zu bestimmen. In diesem Fall wird der Ladestrom der Batterie ausgewertet und, wenn dieser in etwa dem Gasungsstrom der Batterie entspricht, die Vollladung der Batterie angenommen. Die Ruhespannung der Batterie wird dann auf einen Wert gesetzt, der nahe einer maximal möglichen Ruhespannung der Batterie liegt. Auch zu dieser Methode kann wiederum ein zugehöriger Fehler ermittelt werden. Dieser Fehler wird dann mit dem Fehler einer oder mehrerer anderer Bestimmungsmethoden verglichen und je nach Größe des Fehlers entweder die gemäß der einen oder der anderen Methode bestimmte Ruhespannung herangezogen, um den Ladezustand SOC der Batterie zu berechnen.

Kurze Beschreibung der Zeichnungen

Die Erfindung wird nachstehend anhand der beigefügten Zeichnungen beispielhaft näher erläutert. Es zeigen:

Fig. 1    eine schematische Darstellung einer Batterie mit einem daran angeschlossenen Steuergerät zur Berechnung des Ladezustands der Batterie; und

Fig. 2    ein Flussdiagramm mit den wichtigsten Verfahrensschritten eines Verfahrens zum Bestimmen der Ruhespannung und des Ladezustands der Batterie.

Ausführungsformen der Erfindung

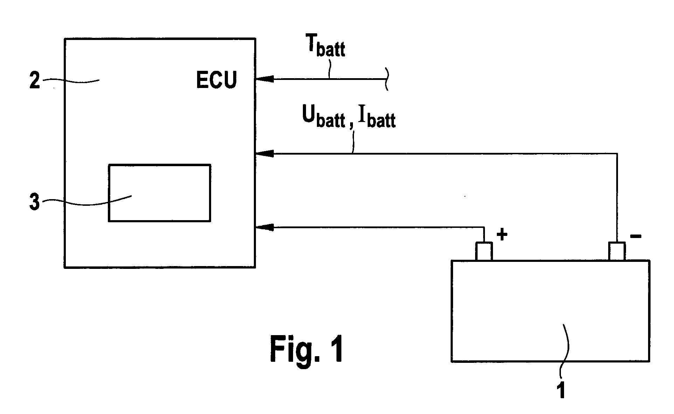

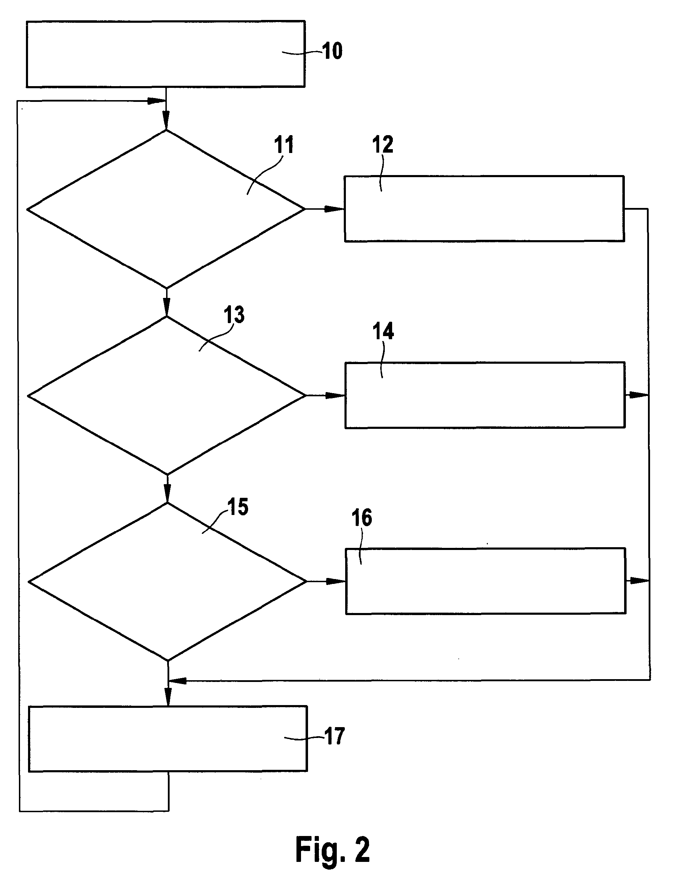

Fig. 1 zeigt eine schematische Ansicht einer Batterie 1 mit einem daran angeschlossenen Steuergerät 2. Das Steuergerät 2 umfasst einen Algorithmus 3 zur Bestimmung der Ruhespannung $U_0$ der Batterie 1 anhand eines Verfahrens, das nachstehend anhand von Fig. 2 näher erläutert werden wird. Der Algorithmus 3 berechnet schließlich aus der Ruhespannung $U_0$ den Ladezustand SOC der Batterie 1.

In dem Verfahren von Fig. 2 werden in einem Schritt 10 zunächst der Initialwert $U_{00}$ der Ruhespannung $U_0$ von Gleichung (1) und der zugehörige Fehler err_$U_0$ auf entsprechende Startwerte (Index init) gesetzt. Danach wird in Schritt 11 der sich aus der Integralmethode (entsprechend Gleichung (1)) ergebende Fehler mit dem Fehler verglichen, der sich bei Anwendung der eingangs genannten zweiten Methode ergeben würde.

Der Fehler der theoretischen Ruhespannung $U_0$, der sich aus der Berechnung der Ruhespannung gemäß der Integralmethode (Gleichung (1)) ergeben würde, kann wie folgt abgeschätzt werden:

$$\text{err}\_U_0 = \text{err}\_U_{00} + \frac{1}{C_0} \int \left( \left| \text{err}\_I_{\text{offset}} \right| + \left| I_{\text{loss}} \right| \right) dt + \left| U_0 - U_{00} \right| \left( \text{err}\_I_{\text{gain}} + \frac{\text{err}\_C_0}{C_0} \right) \quad (2)$$

Dabei ist err_$U_{00}$ der abgeschätzte Fehler für $U_{00}$ in V, err_$I_{\text{offset}}$ der Offsetfehler des Stromsensors in A, err_$I_{\text{gain}}$ der Linearitätsfehler des Stromsensors, $I_{\text{loss}}$ der abgeschätzte Verluststrom, der nicht mehr durch Entladung zurückgewonnen werden kann in A und err_$C_0$ der Bestimmungsfehler der Ersatzkapazität in F.

Der so abgeschätzte Fehler err_$U_0$ erhöht sich infolge der Integration während der Betriebsdauer kontinuierlich.

Um den Wert der Ruhespannung $U_0$ von Zeit zu Zeit zu kalibrieren, wird im Folgenden das Verfahren der Schritte 11 bis 17 durchgeführt. Dabei wird in Schritt 11 zunächst überprüft, ob aus den Batterie-Klemmengrößen, nämlich der Batteriespannung $U_{Batt}$, dem Batteriestrom $I_{Batt}$ und der Batterietemperatur $T_{Batt}$ eine Ruhespannung $U_0$ bestimmt werden konnte. Dies ist üblicherweise nur in solchen Betriebsphasen möglich, in denen die Batterie 1 nicht oder nur geringfügig belastet wird, d.h. der Batteriestrom etwa gleich Null ist.

Außerdem wird in Schritt 11 überprüft, ob der Berechnungsfehler aus der Integrationsmethode err_$U_0$ (entsprechend Gleichungen (1)) größer ist als der Fehler err_$U_{00\_Ruhe}$, der bei einer Berechnung der Ruhespannung Uo gemäß der vorstehend genannten zweiten Methode (Index Ruhe) entstehen würde. Für den Fehler err_$U_{00\_Ruhe}$ gilt:

$$err\_U_{00\_ruhe} = err\_U_{Batt} + err\_I_{Bat}\,\frac{d}{dI_{Bat}}U_{pol}(I_{Batt}, T_{Batt}) +$$

$$err\_T_{Batt}\,\frac{d}{dT_{Batt}}U_{pol}(I_{Batt}, T_{Batt}) + err\_extrapol + err\_strat \qquad (3)$$

Dabei ist $err\_U_{Batt}$ der Messfehler des Spannungssensors in V, $err\_I_{Batt}$ der Messfehler des Stromsensors in A, $err\_T_{batt}$ der Messfehler des Temperatursensors in K, err_extrapol, der abgeschätzte Bestimmungsfehler aufgrund dynamischer Einschwingvorgänge in V, err_strat, der abgeschätzte Bestimmungsfehler durch aufgebaute Säureschichtung und $U_{pol}$ die berechnete Kompensationsspannung aufgrund des Ruhestroms und der Temperatur.

Sofern der Fehler $err\_U_0$ größer ist als der mögliche Fehler $err\_U_{00\_Ruhe}$ (Fall ja) wird in Schritt 12 der Initialwert $U_{00}$ von Gleichung (1) auf den Wert $U_{00\_Ruhe}$ gesetzt, der sich aus der Schätzmethode ergibt. Außerdem wird der Fehlerwert $err\_U_{00}$ auf den Fehlerwert $err\_U_{00\_Ruhe}$ des Schätzverfahrens gesetzt. Des Weiteren wird die SOC-Integration, die schließlich in Schritt 17, z.B. gemäß Gleichung (1) durchgeführt wird, zurückgesetzt.

Wenn eine der Bedingungen von Schritt 11 nicht zutrifft (Fall nein) wird in Schritt 13 überprüft, ob der Berechnungsfehler aus der Integrationsmethode $err\_U_0$ (entsprechend Gleichungen (1)) größer ist als der Fehler $err\_U_{00\_fullcharge}$, der sich bei einer Anwendung der eingangs genannten dritten Methode (Volladungserkennung) entstehen würde. Zunächst wird jedoch ermittelt, ob die Batterie 1 voll geladen ist. Eine Volladung wird üblicherweise angenommen, wenn der Ladestrom der Batterie gegen den angenommenen Gasungsstrom der Batterie sinkt. In diesem Fall wird die Ruhespannung U0 einfach auf einen Wert gesetzt, der nahe der maximalen Ruhespannung liegt.

Der Fehler dieser dritten Methode (Index fullcharge) kann z. B. anhand von Messreihen über ein Kennfeld bestimmt werden:

$$err\_U_{00\_fullcharge} = f(U_{batt}, T_{batt}, t_{charge})$$

dabei ist $t_{charge}$ die Dauer der Ladephase in s.

Sofern der Fehler $err\_U_0$ in Schritt 13 größer ist als der Fehler $err\_U_{00\_fullcharge}$ (Fall ja) wird in Schritt 14 die Ruhespannung $U_0$ gemäß der vorstehend beschriebenen Vollladungsmethode bestimmt und der Initialwert $U_{00}$ von Gleichung (1) auf diesen Wert $U_{00\_fullcharge}$ gesetzt. Darüber hinaus wird der Fehler $err\_U_{00}$ auf den entsprechenden Fehler $err\_U_{00\_fullcharge}$ gesetzt und die SOC-Integration zurückgesetzt.

Falls die in Schritt 13 vorgegebenen Bedingungen nicht erfüllt sind (Fall nein) kann in Schritt 15 überprüft werden, ob ein Ergebnis weiterer Methoden zur Ruhespannungsberechnung vorliegt. Danach erfolgt wiederum ein Vergleich des zugehörigen Fehlerwertes mit dem Fehlerwert $err\_U_0$ und gegebenenfalls eine entsprechende Anpassung der Werte $U_{00}$ und $err\_U_{00}$ in Schritt 16.

Sofern keine weiteren Methoden zur Ruhespannungsbestimmung vorgesehen sind, werden die Schritte 15 und 16 übersprungen.

Das Verfahren verzweigt danach wieder zurück zu Schritt 11.

**Patentansprüche**

1. Verfahren zum Ermitteln des Ladezustands (SOC) einer Batterie (1) aus einer Ruhespannung der Batterie (1), **dadurch gekennzeichnet, dass**

- eine Ruhespannung ($U_0$) der Batterie (1) mittels einer ersten Methode berechnet wird, bei der die Ruhespannung ($U_0$) durch Integration des Batteriestroms ($I_{Batt}$) über die Zeit ermittelt wird; und
- ein erster Fehler ($err\_U_0$) der Ruhespannung ($U_0$) berechnet wird, der sich bei der Berechnung mittels der ersten Methode ergeben würde, wobei der erste Fehler ($err\_U_0$) in Abhängigkeit eines Initialwerts ($err\_U_{00}$) berechnet wird;
- eine Ruhespannung ($U_{0\_Ruhe}$) der Batterie (1) mittels einer zweiten Methode ermittelt wird, bei der die Ruhespannung ($U_{0\_Ruhe}$) aus der Klemmenspannung ($U_{Batt}$), dem Batteriestrom ($I_{Batt}$) und der Batterie-Temperatur ($T_{Batt}$) in einer Ruhephase der Batterie (1) geschätzt wird; und
- ein zweiter Fehler ($err\_U_{0\_Ruhe}$) der Ruhespannung berechnet wird, der sich bei einer Anwendung der zweiten Methode ergeben würde; und
- der Ladezustand (SOC) mit derjenigen Methode ermittelt wird, deren Fehler ($err\_U_0$, $err\_U_{0\_Ruhe}$) minimal ist;

und
- der Initialwert (err_$U_{00}$) auf den abgeschätzten zweiten Fehler (err_$U_{0\_Ruhe}$) der Ruhespannung gesetzt wird, wenn der erste Fehler (err_$U_0$) größer ist als der zweite Fehler (err_$U_{0\_Ruhe}$).

2. Verfahren nach Anspruch 1, **dadurch gekennzeichnet, dass** eine Ruhespannung ($U_{0\_fullcharge}$) der Batterie (1) mittels einer dritten Methode ermittelt wird, bei der die Ruhespannung ($U_{0\_fullcharge}$) aus einer Vollladungserkennung der Batterie (1) geschätzt wird, und ein dritter Fehler (err_$U_{0\_fullcharge}$) der Ruhespannung ($U_0$) berechnet wird, der sich bei einer Anwendung der dritten Methode ergeben würde.

3. Verfahren nach Anspruch 2, **dadurch gekennzeichnet, dass** der Fehler (err_$U_0$) aus der Integration des Batteriestroms ($I_{Batt}$) mit dem Fehler (err_$U_{0\_fullcharge}$), der sich aus einer Vollladungserkennung gemäß Anspruch 2 ergeben würde, verglichen wird.

4. Steuergerät, umfassend einen Algorithmus zum Durchführen eines der vorstehend genannten Verfahren.

## Claims

1. Method for determining the state of charge (SOC) of a battery (1) from a no-load voltage of the battery (1), **characterized in that**

   - a no-load voltage ($U_0$) of the battery (1) is calculated by means of a first method in which the no-load voltage ($U_0$) is determined by integration of the battery current ($I_{Batt}$) with respect to time; and
   - a first error (err_$U_0$) of the no-load voltage ($U_0$), which error would be produced in the event of calculation by means of the first method, is calculated, wherein the first error (err_$U_0$) is calculated as a function of an initial value (err_$U_{00}$);
   - a no-load voltage ($U_{0\_no\_load}$) of the battery (1) is determined by means of a second method in which the no-load voltage ($U_{0\_no-load}$) is estimated from the terminal voltage ($U_{Batt}$), the battery current ($I_{Batt}$) and the battery temperature ($T_{Batt}$) in a no-load phase of the battery (1); and
   - a second error (err $U_{0\_no-load}$) of the no-load voltage, which error would be produced in the event of the second method being used, is calculated; and
   - the state of charge (SOC) is determined with that method in which the error (err_$U_0$, err_$U_{0\_no-load}$) is minimal; and
   - the initial value (err_$U_{00}$) is set to the estimated second error (err $U_{0\_no-load}$) of the no-load voltage when the first error (err_$U_0$) is greater than the second error (err_$U_{0\_no-load}$).

2. Method according to Claim 1, **characterized in that** a no-load voltage ($U_{0\_fullcharge}$) of the battery (1) is determined by means of a third method in which the no-load voltage ($U_{0\_fullcharge}$) is estimated from a full charge of the battery (1) being identified, and a third error (err_$U_{0\_fullcharge}$) of the no-load voltage ($U_0$), which error would be produced in the event of the third method being used, is calculated.

3. Method according to Claim 2, **characterized in that** the error (err_$U_0$) from the integration of the battery current ($I_{Batt}$) is compared with the error (err_$U_{0\_fullcharge}$) which would be produced from a full charge being identified according to Claim 2.

4. Controller comprising an algorithm for carrying out one of the abovementioned methods.

## Revendications

1. Procédé pour déterminer l'état de charge (SOC) d'une batterie (1) à partir d'une tension de repos de la batterie (1), **caractérisé en ce que**

   - une tension de repos ($U_0$) de la batterie (1) est calculée au moyen d'une première méthode, dans laquelle la tension de repos ($U_0$) est déterminée par intégration du courant de la batterie ($I_{Batt}$) dans le temps ; et
   - une première erreur (err_$U_0$) de la tension de repos ($U_0$) est calculée, laquelle serait obtenue lors du calcul au moyen de la première méthode, la première erreur (err_$U_0$) étant calculée en fonction d'une valeur initiale (err_$U_{00}$) ;

- une tension de repos ($U_{0\_Ruhe}$) de la batterie (1) est déterminée au moyen d'une deuxième méthode, dans laquelle la tension de repos ($U_{0\_Ruhe}$) est estimée à partir de la tension aux bornes ($U_{Batt}$), du courant de la batterie ($I_{Batt}$) et de la température de la batterie ($T_{Batt}$) dans une phase de repos de la batterie (1) ; et
- une deuxième erreur (err_$U_{0\_Ruhe}$) de la tension de repos est calculée, laquelle s'obtiendrait en utilisant la deuxième méthode ; et
- l'état de charge (SOC) est déterminé avec la méthode dont l'erreur (err_$U_0$, err_$U_{0\_Ruhe}$) est minimale ; et
- la valeur initiale (err_$U_{00}$) est mise à la deuxième erreur estimée (err_$U_{0\_Ruhe}$) de la tension de repos, lorsque la première erreur (err_$U_0$) est supérieure à la deuxième erreur (err_$U_{0\_Ruhe}$).

2. Procédé selon la revendication 1, **caractérisé en ce qu'**une tension de repos ($U_{0\_fullcharge}$) de la batterie (1) est déterminée au moyen d'une troisième méthode dans laquelle la tension de repos ($U_{0\_fullcharge}$) est estimée à partir d'une reconnaissance de pleine charge de la batterie (1), et une troisième erreur (err_$U_{0\_fullcharge}$) de la tension de repos ($U_0$) est calculée, laquelle serait obtenue en utilisant la troisième méthode.

3. Procédé selon la revendication 2, **caractérisé en ce que** l'erreur (err_$U_0$) obtenue à partir de l'intégration du courant de la batterie ($I_{Batt}$) est comparée avec l'erreur (err_$U_{0\_fullcharge}$) qui serait obtenue à partir d'une reconnaissance de pleine charge selon la revendication 2.

4. Appareil de commande comprenant un algorithme pour mettre en oeuvre l'un des procédés susmentionnés.

Fig. 1

EP 2 318 853 B1

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1308738 A2